(19) Europäisches Patentamt
European Patent Office
Office européen des brevets

(11) **EP 2 418 634 A1**

(12) **EUROPEAN PATENT APPLICATION**

(43) Date of publication:
**15.02.2012 Bulletin 2012/07**

(51) Int Cl.:
***G08G 1/14*** *(2006.01)*  ***G01S 17/02*** *(2006.01)*
***H03K 21/00*** *(2006.01)*

(21) Application number: **11382275.3**

(22) Date of filing: **09.08.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.08.2010 ES 201031243**

(71) Applicant: **Circontrol S.A.**
**08232 Viladecavalls (ES)**

(72) Inventor: **Comellas Cabeza, Joan**
**08232 VILADECAVALLS (ES)**

(74) Representative: **Sugrañes Patentes y Marcas**
**Calle Provenza 304**
**08008 Barcelona (ES)**

(54) **Device and method for detecting the presence of a vehicle in a parking space**

(57)     The present invention relates to a device for detecting the presence of a vehicle in a parking space which in addition to signaling means for signaling the presence of a vehicle also comprises optical emitting means and corresponding optical detecting means; processing means for processing the optical signal detected to obtain a first train of pulses x[n] the amplitude of which is proportional to the distance between the device and the target or the floor; a statistical unit comprising a plurality of registers for storing the amplitude values of a predetermined number of consecutive pulses obtained and calculating means for calculating a statistical function with the value from said registers; and a verifying unit evaluating whether the result of the statistical function is above a target threshold value (umbB) during a predetermined time period to trigger an activation signal for activating the signaling means.

**Fig. 1**

**Description**

**Technical Sector of the Invention**

The invention relates to a device and a method for detecting the presence of a vehicle in a parking space.

**Background of the Invention**

Parking lots provided with several successive lanes in which parking spaces which can be free or occupied by a vehicle are found at either side of said lane. There are different devices for detecting the presence of a vehicle in one of the several parking spaces by means of using ultrasound signals. These devices emit an ultrasound signal which is reflected on the target and is received by the device, calculating the distance at which the target is located according to the delay by way of sonar and deciding according to the value of this distance if the parking space is free or occupied. These devices have the drawback of requiring to locate a sensor element in the ceiling part located above the parking space and a signaling element for signaling the presence of a vehicle in said parking space, separated from the sensor element, located outside the parking space, since the parking lots are normally provided with columns which do not allow seeing all the ceiling. Said signaling elements are located in the ceiling part above the central lane adjacent to said parking space, allowing to be seen by the drivers of vehicles passing through the lane searching for a free space. Therefore these devices must be formed by an independent sensor element and signaling element making the manufacturing and installation thereof more expensive and difficult.

Devices using infrared optical signals, such as the one described in the patent document FR2659147, provided with an infrared emitter and two infrared detectors calibrated such that the infrared emitter emits an optical signal towards the space which upon being reflected by the floor must be received only by a detector, confirming that the parking space is not occupied, are known. In the event that said parking space is occupied, said optical signal must be further received by the other detector, confirming the presence of a vehicle in the parking space. Since the arrangement of said emitter and receivers are fixed, it means that if a vehicle is very high or very low it will not be suitably detected. This device further has the drawback that the emitter and the receivers must be sufficiently separated for allowing the reflected signal to be captured correctly, not being able to be encapsulated in a compact device. Another drawback that said device has is that this must be located in the ceiling part located above the parking space, also requiring individual signaling elements located in the ceiling part adjacent to said parking space.

Patent document FR2919417 describes a device formed by an emitter and at least one infrared receptor suitable for detecting the presence of a vehicle in a parking space by means of the reflection of the optical infrared signal in elements of the vehicle, such as the headlights or the license plate, the backlight coefficient of which is high. This solution implies that it is difficult to calibrate the direction for emitting and receiving the optical signal so that this falls directly on one of said elements with high backlight coefficient when the vehicle is parked. Furthermore, the arrangement of said elements vary according to the type of vehicle or can even be that the vehicle is lacking of them, therefore the vehicle parked in the parking space would not be detected correctly. Therefore, although this solution is suitable to prevent the detection of a target which comes temporarily between the optical infrared signal with a low backlight coefficient, such as a pedestrian who crossed through the parking space momentarily, it is very possible that a parked vehicle is not correctly detected.

It is therefore a main objective of the present invention to disclose a device which, being compact allows detecting a vehicle parked in a parking space regardless of the size and components thereof, preventing wrong detections.

**Summary of the Invention**

The device for detecting the presence of a vehicle in a parking space of the present invention is of those comprising signaling means for signaling the presence of a vehicle.

Essentially, the device is characterized in that it comprises optical emitting means and corresponding optical detecting means, emitting and receiving an optical signal of a same wavelength, oriented towards the parking space and suitable so that when said emitting means emit an optical signal towards the parking space, the reflection of said optical signal on the floor of said parking space or on a target coming between it, is received by the detecting means; processing means of said optical signal to obtain a train of pulses the amplitude of which is proportional to the distance between the device and the target or the floor; a statistical unit comprising a plurality of registers for storing the amplitude values of a predetermined number of consecutive pulses obtained, and calculating means for calculating a statistical function with the value from said registers; and a verifying unit evaluating whether the result of the statistical function is above a target threshold value during a predetermined time period to trigger an activation signal for activating the signal display means. It is thus possible to encapsulate the different components forming the device in a compact box, which can be located in the central lane of a parking space, adjacent to the parking space which it controls, and therefore it will be seen by the drivers passing through said central lane in search of a free space. Since it is provided with a statistical unit and a verifying unit, false positives such as for example, mistaking a pedestrian passing through the parking space as a parked vehicle, are prevented.

In a variant of the invention, the device also comprises an evaluating unit or a plurality of evaluating units connected in series each provided with a comparator adjusted to a predetermined threshold and an integrator to accumulate the results of said comparator, said evaluating unit being connected between the statistical unit and the verifying unit which allow reasserting that the detection of a parked vehicle is correct, assuring that false positives are not detected.

According to another variant of interest, the units are encapsulated in a microcontroller allowing the device to be more compact and easy-to-programme.

In another variant, the optical signal emitted and received by the optical emitting means and the optical detecting means, respectively, has infrared wavelength which allow detecting the presence of a vehicle without visible light affecting the measurement. To assure that other wavelengths do not affect the measurement, the optical detecting means can be provided with a band pass optical filter at the wavelength of interest which only allows receiving in said wavelength.

In another variant, the device further comprises transmission means for transmitting the presence of said vehicle to a remote station which allow activating other signaling elements of the parking space to efficiently guide the vehicles towards the lots indicated as free or to activate or deactivate a signal of complete parking.

Essentially, the method for detecting the presence of a vehicle in a parking space is characterized in that it comprises the steps of emitting an optical signal towards the parking space; receiving the optical signal reflected by a target or by the floor of the parking space; obtaining a train of pulses the amplitude of which is proportional to the distance between the device and the target or the floor from said optical signal received; storing the amplitude values of a predetermined number of consecutive pulses obtained; performing a statistical operation on the stored values; verifying that the value from the result of said statistical operation is kept above of a threshold during a predetermined time period and if it is so, activating signaling means for signaling the presence of a vehicle in the parking space, preventing false positives such as for example, mistaking a pedestrian passing through the parking space as a parked vehicle.

In a variant of the method, this further comprises the operation of comparing the value of the statistical operation with a comparator, adjusted to a predetermined threshold level to obtain a different value according to the input value be it greater or less than said threshold at the output of the comparator; and accumulating the values obtained by said comparator.

## Brief Descriptions of the Drawings

A variant of the device according to the invention has been depicted in the attached drawings. Specifically:

Figure 1 is a cross-section view of a variant of the device of the invention; and
Figure 2 is a diagram of the operation of the interconnected units of the device.
Figure 3a is a view of one section of a parking lot provided with the device of the invention with a free parking space;
Figure 3b is a view of the section of the parking lot of Figure 3a with a temporary target in the free parking space;
Figure 3c is a view of the section of the parking lot of Figure 3a with a vehicle parked in the previously free parking space;

## Detailed Description of the Invention

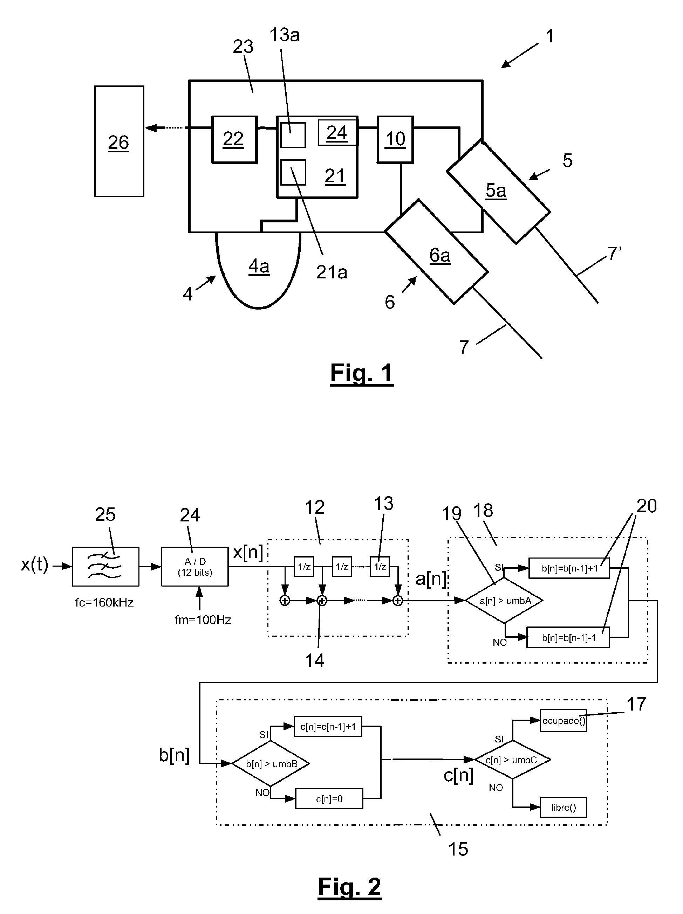

Figure 1 depicts a variant of the device 1 for detecting the presence of a vehicle in a parking space. It can be observed in said Figure 1 that the device 1 is formed by a closed box 23 housing the electronic components of said device 1 and protecting them from the outside. The variant shown in Figure 1 comprises signal display means 4, in this case a set of signaling LEDs 4a which must be switched on when the parking space 3 is free. Alternatively, the device 1 can be provided with two sets of signaling LEDs, one of red LEDs and another of green LEDs to indicate, like a traffic light, if the adjacent parking space is free or occupied and transmission means 22 to indicate to a remote station 26 if said parking space is free or occupied. The remote station 26 can activate other signaling elements of the parking lot to efficiently guide the vehicles towards the lots indicated as free or to activate or deactivate a signal of complete parking in a manner known in the state of the art.

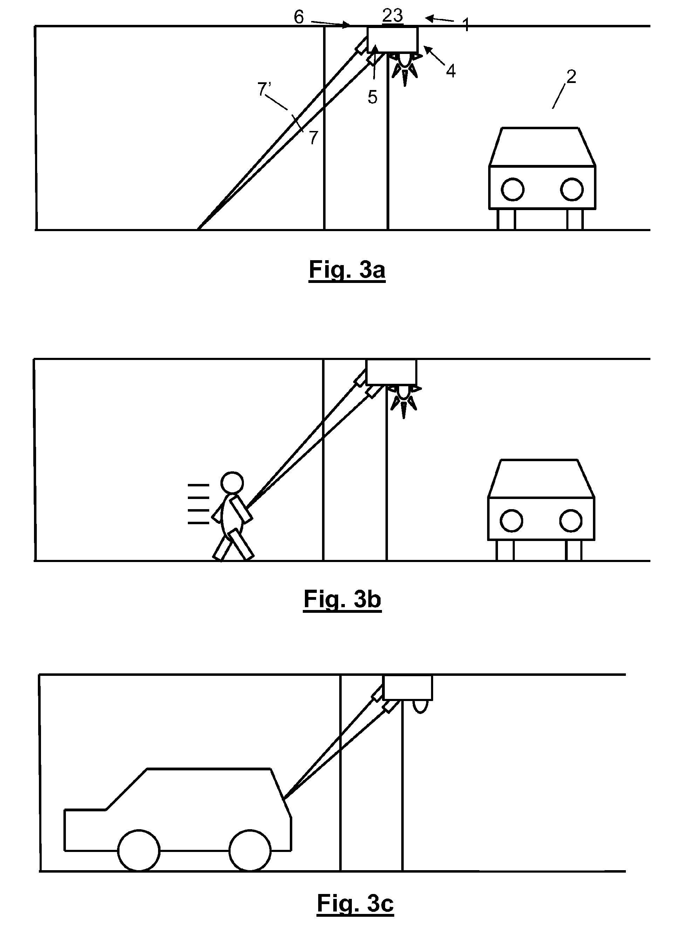

To detect whether a parking space 3 is free or occupied, the device 1 is provided with highly directional optical emitting means 5 formed in this case by an infrared LED 5a and oriented so that they emit an optical infrared signal 7 with a wavelength of about 870 nm towards the parking space, such as shown in Figures 3a to 3c. The optical signal 7 is dispersed upon being reflected on the floor 8 of said parking space 3 or on a target 9, this being able to be a vehicle 2 or another obstacle coming between the path of the optical signal 7, a reflected optical signal 7' which is received by corresponding optical detecting means 6 with high directivity in the direction of the path of the optical signal 7 formed in this case by a photodiode 6a being generated.

As can be observed in Figure 1, the device 1 comprises processing means 10 comparing the intensity of the emitted optical signal 7 with the intensity of the reflected optical signal 7' to determine the distance at which the possible target 9 is, or in its absence the floor 8. Naturally, other variants of the invention can use other LiDAR techniques such as for example, determining the distance by means of calculating the phase shift between laser pulses emitted and received.

By means of this comparison, the processing means 10 obtain an analog signal **x(t)** shown in Figure 2 which is filtered by means of a low-pass analog filter 25 with 160kHz cut-off frequency to eliminate noise and peaks produced by specific interferences. The processing means 10 then input this filtered analog signal **x(t)** to an input of the microcontroller 21 provided with a 12 bit analog/digital converter 24 which performs samplings at low frequency, in this case sampling is performed at 100Hz, therefore a sample of the filtered analog signal **x(t)** which will form a first train of pulses **x[n]** the amplitude of which will be proportional to the measurement of the distance between the device and a possible target or the floor will be obtained every 10 ms.

The microcontroller 21 comprises a processor 21 a and a memory 13a suitable to implement the different units 12, 18, 15 forming part of the device 1. As can be observed in Figure 2, the statistical unit 12, as each pulse of the first train of pulses **x[n]** arrives, stores the value of said pulse in a register 13, by way of shift register, which in the variant shown in Figure 2 comprises 15 registers 13. Thus the amplitude values of 15 consecutive pulses are stored, and the processor 21a performing the function of calculating means 14 sums up the stored values in said registers 13 together with the value of the pulse at the input 12, a second train of pulses **a[n]** also of 100Hz frequency being obtained at the output of the statistical unit according to:

$$a[n] = \sum_{i=0}^{15} x[n-i]$$

Other alternative statistical operations which would serve to standardize the value of a set of consecutive pulses of the first train of pulses x[n], such as to perform an arithmetic mean or a low-pass digital filter could be equally performed by the processor 21.

Although in the variant shown in Figure 1 both the statistical unit 12 like the other units forming part of the device 1 are implemented in a programmable microcontroller 21 provided with a processor 21 a and a memory 13a since this solution is fast and economic. However, other alternative implementations such as using tailor made integrated circuit or discrete components are also contemplated.

To prevent false positives in the detection of a target 9 such as for example in the condition shown in Figure 3b in which a pedestrian temporarily comes between the device 1 and the floor 8 of the parking space 3, the second train of pulses **a[n]** is introduced in an evaluating unit 18 provided with a comparator 19 adjusted to a predetermined threshold **umbA** equivalent to the distance of detection of the target 9 and an integrator 20 to accumulate the results of said comparator, generating a third train of pulse **b[n]** also of 100Hz frequency, the successive values of which will be increased in a unit or will be decreased in a unit according to the amplitude of the last pulse of the second train of pulses **a[n]** exceeding or not exceeding the predetermined threshold **umbA**, respectively, according to:

$$\begin{cases} b[n] = b[n-1] + 1 & a[n] > umbA \\ b[n] = b[n-1] - 1 & a[n] <= umbA \end{cases}$$

Said third train of pulses **b[n]** is introduced in a verifying unit 15 having the consecutive pulses of said third train of pulses **b[n]** which are above a target threshold value **umbB**, generating a frequency counter train of pulses c[n] also of 100Hz the value of which is increased each time that a pulse of the third train of pulses **b[n]** exceeds the target threshold value **umbB** and the value of which is reinitiated when a pulse of the third train of pulses **b[n]** does not exceed said target threshold **umbB** following the ratio:

$$\begin{cases} c[n] = c[n-1]+1 & b[n] > umbB \\ c[n] = 0 & b[n] <= umbB \end{cases}$$

Finally, when a predetermined value **umbC** of pulses of the third train of pulses **b[n]** exceeding the target threshold value **umbB** is exceeded, an activation signal 17 for activating the signaling means 4 is triggered. In the variant depicted, the predetermined value **umbC** is 300 samples necessarily implying that there must be a detection of a target 9 for at least 3 seconds for triggering the activation signal 17 of the signaling means 4 and indicating that the parking space 3 is occupied. By means of this delay, accumulated to the delays accumulated by the low-pass filter 25 and by the other digital units 12, 18, the signaling means 4 are not activated upon detecting a moving target 9.

As can be observed in Figure 3a, when the device 1 of the present invention is installed in a parking space 3, it allows its signaling means 4 to be seen from the lane through which the vehicles 2 wishing to park pass at the same time that the parking space 3 is confirmed as not being occupied.

Advantageously, as observed in Figure 3b, when a temporary target 9 passes through the parking space 3, although the distance measured by the processing means 10 will be the distance suitable to activate the signaling means 4, the delay introduced by the statistical unit 12, the evaluating unit 18 and the verifying unit 15 allow that the signaling means 4 are not activated.

Contrarily and as shown in Figure 3c, when a vehicle 2 parks correctly in the parking space 3, the latter will come between the path of the optical signal 7 emitted by the emitting means 5, the reflected optical signal 7' being captured by the detecting means 6 and the processing means 10 will measure a suitable distance so that after it is processed by the statistical unit 12, the evaluating unit 18 and the verifying unit 15, according to the aforementioned method, activate the signaling means 4 until the vehicle 2 is removed from the parking space 3 in which the signaling means 4 will be deactivated returning to the condition shown in Figure 3a.

## Claims

1.   A device (1) for detecting the presence of a vehicle (2) in a parking space (3) comprising signaling means (4) for signaling the presence of a vehicle, **characterized in that** it also comprises:

- optical emitting means (5) and corresponding optical detecting means (6) emitting and receiving an optical signal (7) of a same wavelength, oriented towards the parking space and suitable so that when said emitting means emit an optical signal towards the parking space, the reflection of said optical signal on the floor (8) of said parking space or on a target (9) coming between it, is received by the detecting means;

- processing means (10) for processing said optical signal to obtain a first train of pulses x[n] the amplitude of which is proportional to the distance between the device and the target or the floor;

- a statistical unit (12) comprising a plurality of registers (13) for storing the amplitude values of a predetermined number of consecutive pulses obtained and calculating means (14) for calculating a statistical function with the value from said registers; and

- a verifying unit (15) evaluating whether the result of the statistical function is above a target threshold value (umbB) during a predetermined time period to trigger an activation signal (17) for activating the signaling means.

2.   The device (1) according to the preceding claim, **characterized in that** it comprises a evaluating unit (18) or a plurality of evaluating units connected in series, each provided with a comparator (19) adjusted to a predetermined threshold (20) and an integrator (20) to accumulate the results of said comparator, said evaluating unit being connected between the statistical unit (12) and the verifying unit (15).

3.   The device (1) according to any one of the preceding claims, **characterized in that** the units are implemented in a microcontroller (21).

4.   The device (1) according to any one of the preceding claims, **characterized in that** the optical signal (7) emitted and received by the optical emitting means (5) and the optical detecting means (6), respectively, has infrared wavelength.

5.   The device (1) according to any one of the preceding claims, **characterized in that** it further comprises transmission means (22) for transmitting the presence of said vehicle (2) to a remote station.

6. A method for detecting the presence of a vehicle (2) in a parking space (3), **characterized in that** it comprises the steps of:

- emitting an optical signal (7) towards the parking space;
- receiving the optical signal reflected by a target (9) or by the floor (8) of the parking space;
- obtaining a first train of pulses x[n] the amplitude of which is proportional to the measurement of the distance between the device and the target (9) or the floor (8) from said optical signal received;
- storing the amplitude values of a predetermined number of consecutive pulses obtained;
- performing a statistical operation on the stored values;
- verifying that the value from the result of said statistical operation is kept above of a threshold value during a predetermined time period and if it is so, activating signaling means (4) for signaling the presence of a vehicle in the parking space.

7. The method according to claim 6, **characterized in that** it further comprises the operation of:

- comparing the value of the statistical operation with a comparator adjusted to a predetermined level threshold to obtain, at the output of the comparator, a different value according to the input value be it greater or less than said threshold; and
- accumulating the values obtained by said comparator.

**Fig. 1**

**Fig. 2**

**Fig. 3a**

**Fig. 3b**

**Fig. 3c**

**EP 2 418 634 A1**

---

Europäisches Patentamt
European Patent Office
Office européen des brevets

## EUROPEAN SEARCH REPORT

Application Number

EP 11 38 2275

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 1 530 183 A2 (HIGHLIGHT PARKING SYSTEMS LTD [GB]) 11 May 2005 (2005-05-11)<br>* abstract *<br>* paragraphs [0001], [0009], [0013] - [0016], [0019], [0021], [0023], [0025] - [0029], [0034], [0037] *<br>* claims 1,10-13,15 *<br>* figures 1, 4, 6, 7 * | 1-7 | INV.<br>G08G1/14<br>G01S17/02<br>H03K21/00 |
| Y | WO 00/55821 A1 (INTELLIGENT DEVICES INC [US]) 21 September 2000 (2000-09-21)<br>* abstract *<br>* page 4, line 13 - page 6, line 32 *<br>* page 11, lines 16-28 *<br>* page 13, line 24 - page 14, line 6 *<br>* claims 1,2,34 *<br>* figure 5 * | 1-7 | |
| A | US 6 163 253 A (YARON MICHAEL [US] ET AL) 19 December 2000 (2000-12-19)<br>* abstract *<br>* figures 5,6 *<br>* column 1, lines 10-16 *<br>* column 1, line 41 - column 3, line 6 *<br>* column 6, lines 11-33 *<br>* column 7, lines 28-52 *<br>* claims 1,3,9,10,14 * | 1-7 | TECHNICAL FIELDS SEARCHED (IPC)<br>G08G<br>G01S<br>H03K |
| A | US 2004/184566 A1 (WAHL MARK A [US] ET AL) 23 September 2004 (2004-09-23)<br>* abstract *<br>* figures 1, 2 *<br>* paragraphs [0002], [0004], [0011], [0013] - [0015], [0021], [0025], [0026], [0029], [0030], [0033] *<br>* claims 1,2,4,9,10,16 * | 1-7 | |

-/--

The present search report has been drawn up for all claims

| Place of search | Date of completion of the search | Examiner |
|---|---|---|
| The Hague | 28 November 2011 | Quartier, Frank |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

9

Europäisches
Patentamt

European
Patent Office

Office européen
des brevets

**EUROPEAN SEARCH REPORT**

Application Number

EP 11 38 2275

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 2 302 410 A1 (AGLA ELETTRONICA S R L [IT]) 30 March 2011 (2011-03-30)<br>* abstract *<br>* paragraphs [0001], [0008], [0010], [0011], [0014] - [0016], [0018], [0020], [0024], [0025], [0030] *<br>* claims 1,2,4 *<br>* figure 4 *<br>----- | 1-7 | |

TECHNICAL FIELDS
SEARCHED      (IPC)

The present search report has been drawn up for all claims

| Place of search | Date of completion of the search | Examiner |
|---|---|---|
| The Hague | 28 November 2011 | Quartier, Frank |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 11 38 2275

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2011

| Patent document cited in search report | | Publication date | Patent family member(s) | | Publication date |
|---|---|---|---|---|---|
| EP 1530183 | A2 | 11-05-2005 | EP | 1530183 A2 | 11-05-2005 |
| | | | GB | 2408132 A | 18-05-2005 |
| WO 0055821 | A1 | 21-09-2000 | AU | 3619800 A | 04-10-2000 |
| | | | WO | 0055821 A1 | 21-09-2000 |
| US 6163253 | A | 19-12-2000 | AU | 6882398 A | 17-05-1999 |
| | | | CA | 2310570 A1 | 06-05-1999 |
| | | | EP | 1019265 A1 | 19-07-2000 |
| | | | US | 5945907 A | 31-08-1999 |
| | | | US | 6163253 A | 19-12-2000 |
| | | | WO | 9921733 A1 | 06-05-1999 |
| US 2004184566 | A1 | 23-09-2004 | NONE | | |
| EP 2302410 | A1 | 30-03-2011 | NONE | | |

EPO FORM P0459

For more details about this annex : see Official Journal of the European Patent Office, No. 12/82

**EP 2 418 634 A1**

## REFERENCES CITED IN THE DESCRIPTION

### Patent documents cited in the description

- FR 2659147

- FR 2919417